(19) Europäisches Patentamt
European Patent Office
Office européen des brevets

(11) **EP 3 695 514 B1**

(12) **EUROPEAN PATENT SPECIFICATION**

(45) Date of publication and mention
of the grant of the patent:
**19.07.2023 Bulletin 2023/29**

(21) Application number: **17928567.1**

(22) Date of filing: **10.10.2017**

(51) International Patent Classification (IPC):
*H03M 13/13* (2006.01)     *H04L 1/00* (2006.01)
*H03M 13/35* (2006.01)

(52) Cooperative Patent Classification (CPC):
**H03M 13/13; H03M 13/356; H04L 1/0041;**
**H04L 1/0057; H04L 1/0072; H04L 1/0088**

(86) International application number:
**PCT/CN2017/105555**

(87) International publication number:
**WO 2019/071434 (18.04.2019 Gazette 2019/16)**

(54) **POLAR CODING TECHNIQUES**

POLARE CODIERUNGSTECHNIKEN

TECHNIQUES DE CODAGE POLAIRE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(43) Date of publication of application:
**19.08.2020 Bulletin 2020/34**

(73) Proprietor: **ZTE Corporation**
**Shenzhen, Guangdong 518057 (CN)**

(72) Inventors:
• **CHEN, Mengzhu**
**Shenzhen**
**Guangdong 518057 (CN)**
• **XU, Jin**
**Shenzhen**
**Guangdong 518057 (CN)**
• **XU, Jun**
**Shenzhen**
**Guangdong 518057 (CN)**

(74) Representative: **Vossius & Partner**
**Patentanwälte Rechtsanwälte mbB**
**Siebertstrasse 3**
**81675 München (DE)**

(56) References cited:
**EP-A1- 3 454 491      WO-A1-2019/033078**
**CN-A- 103 220 001     CN-A- 106 685 434**
**CN-B- 105 009 541**

• ZTE ET AL: "Joint coding scheme for UCI", 3GPP
DRAFT; R1-1718413 JOINT CODING SCHEME
FOR UCI_FINAL, 3RD GENERATION
PARTNERSHIP PROJECT (3GPP), MOBILE
COMPETENCE CENTRE ; 650, ROUTE DES
LUCIOLES ; F-06921 SOPHIA-ANTIPOLIS
CEDEX ; FRANCE , vol. RAN WG1, no. Prague,
Czechia; 20171009 - 20171013 8 October 2017
(2017-10-08), XP051341595, Retrieved from the
Internet:
URL:http://www.3gpp.org/ftp/Meetings_3GPP_
SYNC/RAN1/Docs/ [retrieved on 2017-10-08]

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

This patent document is directed generally to digital wireless communications.

BACKGROUND

Mobile communication technologies are moving the world toward an increasingly connected and networked society. The rapid growth of mobile communications and advances in technology have led to greater demand for capacity and connectivity. Other aspects, such as energy consumption, device cost, spectral efficiency, and latency are also important to meeting the needs of various communication scenarios. Various techniques, including new ways to provide higher quality of service, are being discussed.

One document of RAN WG1 titled Joint coding scheme for UCI, R1-1718413 Prague, 8.

October 2017, proposes a method, wherein the information including CRI, RI, PTI, PMI and CQI may be jointly encoded, and wherein RI, CRI and PTI shall be placed on the first few indexed of information set.

European patent application EP 3 454 491 A1 is aimed at a method for mapping uplink control information for channel state information feedback, which includes receiving channel state information (CSI) feedback configuration information from a base station, generating (CSI) including at least one of a CSI reference signal resource indicator (CRI), a rank indicator (RI), a precoding matrix indicator (PMI), or a channel quality indicator (CQI) based on the CSI feedback configuration information, identifying an information sequence including the CSI, encoding the information sequence using a polar code, and transmitting the encoded information sequence to a base station wherein the CRI and the RI are placed before padding bits in the information sequence and the PMI and the CQI are placed after the padding bits in the information sequence.

International patent application WO 2019/033078 A1 is aimed at a scenario of a transmission of different CSI components and parts thereof using polar codes, wherein the CSI may comprise (and/or consist of) CRI, RI, PMI, CQI and a required number of bits.

BRIEF SUMMARY

This document discloses methods, systems, and devices related to digital wireless communication, and more specifically, to polar coding techniques of encoding and decoding two types of related information in one set of bits.

The invention is specified by the independent claims. Preferred embodiments are defined in the dependent claims.

The details of one or more implementations are set forth in the accompanying attachments, the drawings, and the description below. Other features will be apparent from the description and drawings, and from the claims.

BRIEF DESCRIPTION OF THE DRAWINGS

FIG. 1 shows an example of decoding two types of information from one 8-bit Polar code.
FIG. 2 shows an example of a wireless communication system where techniques in accordance with one or more embodiments of the present technology can be applied.
FIG. 3 is a block diagram representation of a portion of a radio station.
FIG. 4 is a flowchart representation of a method for wireless communication.
FIG. 5 shows a flowchart representation of another method for wireless communication.

DETAILED DESCRIPTION

The technology and examples of implementations in this document can be used to improve performance in multiuser wireless communication systems. The term "exemplary" is used to mean "an example of" and, unless otherwise stated, does not imply an ideal or a preferred embodiment. Section headers are used in the present document to facilitate understanding and do not limit the disclosed technology in the sections only to the corresponding section.

In information theory, a Polar code is a linear block error correcting code. The code construction is based on a multiple recursive concatenation of a short kernel code which transforms the physical channel into virtual outer channels. When the number of recursions becomes large, the virtual channels tend to either have high reliability or low reliability (in other words, they polarize), and the data bits are allocated to the most reliable channels.

A Polar code can be expressed as $x=u*G$, where u is the input block, x is the coded block and G is the generator matrix of Polar code with a size of N*N, N being a power of 2 number. As the Bit Error Rate (BER) vary, the input block can be placed at proper indices to achieve better performance.

Polar codes have been adopted for the 5G NR (New Radio) interface. For example, polar coding is supported as the channel coding scheme for Downlink (DL) and Uplink (UL) control information. The contents of payload of control channel include Rank Indicator (RI), Channel State Information Reference Signal Resource Index (CRI), Precoding Type Indicator (PTI), Precoding Matrix Indicator (PMI), Channel Quality Indicator (CQI), Acknowledgement (ACK), and Negative-Acknowledgement (NACK), and so on.

Different types of information may be encoded in the same Polar code, which is also known as joint coding. For example, PMI and CQI are based on RI, CRI, and/or PTI and can be jointly coded in the same Polar code. However, some types of information, such as Uplink Control Information (UCI) and Precoding Matrix Indicator (PMI), may have varying lengths, which lead to blind detection of the polar codes on the receiving end. In order and to avoid blind detection, padding bits may be added to achieve the same length for different types of information. However, the Block Error Rate (BLER) can be degraded with such padding bits. Moreover, some types of information, such as ACK , NACK , RI, CRI and/or PTI, may have lower BER performance and/or miss detection requirement. Thus, it may be desirable to distinguish them from other types of information during joint coding.

This patent document describes techniques that leverage joint coding of related types of information in Polar coding to minimize impact to the BLER or BER. In some embodiments, two types of information, Type I and Type II, are encoded in the same Polar code. Information Type II (e.g., including at least one kind of the following information such as ACK, NACK, RI, CRI, and PTI) is carefully placed in the encoded block so that it can be decoded first at the decoding node. Based on the decoded information Type II, length of information Type I can be obtained. For example, the value of information Type II (e.g., RI=1) can indicate the length of information type I (e.g., PMI for codeword indices {0, 1, 2, 3}). By decoding the bits for information Type II (e.g., RI) first, the decoding node can ascertain the length of information type I (e.g., PMI) and decode the PMI information accordingly.

A Polar code has a length of N, wherein N is an integer having a power of 2 value. In general, the Polar code can be constructed using the following parameters: N total bits and K input bits to be encoded. The N bits include the K input bits and a set of (N-K) additional bits. Each of the set of additional bits may have a constant value (e.g., zero). In some implementations, these bits may have a value that is constant across multiple (or all) transmissions. In such cases, the set of additional bits may be referred to as frozen bits, whose placement may impact the BER of the resulting encoded bits. In some implementations, these bits may include an identification string that identifies a communication device, such as the encoding node or the decoding node to which the Polar code is sent. In some embodiments, the additional (N-K) bits may be excluded from the Polar coding. In some cases, K=N so that there is no additional bits, thereby reaching a code rate of 1. However, a code rate of 1 may not be desirable.

K input bits are placed in a set of indices, denoted as set I, before Polar coding. The value of K can vary for different types of input information like ACK, NACK, RI, CRI, PTI, CQI and/or PMI. In some embodiments, the K input bits may also include assistant bits and/or parity check bits. Two types of information, Type I and Type II, can be included in the K input bits of the Polar code. In some embodiments, Type II information may include at least one of the information such as ACK, NACK, RI, CRI, PTI, and the Type I information occupies the remaining indices (i.e., K-k2 indices) in set I. Both types of information may have varying length $k_1$ and $k_2$, wherein $k_1$ and $k_2$ are positive integer numbers. The encoding of the two types of information may include the following steps:

1. Place information Type II into a set S that has specially assigned indices. In some embodiment, the size of set S is greater than the number of bits for information Type II. For example, a subset of indices in the set S is assigned to input bits of information Type II, and the remaining indices in the set S, which can be preconfigured or predefined, do not hold relevant information for information type II. The size of set S is n, wherein n is a positive integer number that is equal to or greater than $k_2$ (i.e., the length of information type II). In some embodiments, the set S may include the smallest indices of the input bit indices, the least reliable indices of the input bit indices, and/or a combination of the smallest indices and the least reliable indices. In some embodiments, the set S may include indices 0, 1, ..., n-1. According to the claimed invention, the set S may include indices N-n, N-n+1, ..., N-1. Alternatively, according to the claimed invention, the indices included in the set S are distributed across all indices, such as

$$\left\lfloor \frac{N}{n} \right\rfloor - 1, \left\lfloor \frac{2N}{n} \right\rfloor - 1, \dots, N\text{-}1$$

. In some embodiments the set S may be a subset of set I. Alternatively, set S and set I may have a common subset of indices, and information Type II is placed in the common subset of indices. The placement of information Type II in the set S is performed such that the encoded bits corresponding to information Type II are self-decodable or can be decoded prior to other bits in K input bits.

2. Place $k_1$ bits of information Type I into the remaining indices (i.e., K-k2 indices) of set I.

3. Encode the N bits using Polar encoding.

The encoding node then transmits the encoded N-bit Polar code. In some embodiments, the encoding node may repeatedly transmit the coded n bits whose indices are included in the set S for a number of times to ensure that information Type II can be correctly decoded.

After receiving the Polar code, the decoding node first decodes n bits in set S for information type II. In some embodiments, the decoding node can extract the log-likelihood ratio (LLR) of encoded bits for Type II information, whose indices are in the set S. For example, it may be known that input bits having indices in set S can be decided by the encoded bits having the same indices. Therefore, the values of the input bits can be obtained based on the LLR values of the encoded bits having the same indices. The decoding node can then derive the length of information Type I accordingly.

In some embodiments, after decoding the bits for information Type II, the decoding node may use the decoded bits $u_k$ as known bits for decoding of the remaining bits for information type I, wherein $k \in S$. In some implementations, the decoding node may descramble the bits for information Type II prior to performing the decoding the information Type I. For example, as a part of descrambling, the decoding node may inverse the sign of log-likelihood ratio $LLR_k$ of any $c_k=1$, while maintaining the sign of $LLR_k$ of any $c_k=0$, where $c_k$ are encoded bits for information Type II. The decoding node may also set the bits in set S (i.e., bits for information Type II) to 0 when it decodes the bits for information Type I.

In some embodiments, the length of Type II information may vary, which leads to a certain amount of blind detection at the decoding node. However, using the techniques disclosed here, the amount of blind detection can be reduced and/or minimized to obtain the correct information for both information Type I and Type II. At the same time, the BER and/or miss detection requirement of information Type II and Type I can also be met.

## Example Embodiment 1

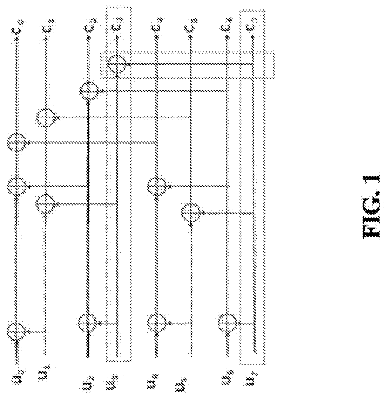

FIG. 1 shows an example of decoding two types of information from one 8-bit Polar code. In this particular example, all 8 bits in the Polar code are input bits such that $I = \{0, 1, 2, 3, 4, 5, 6, 7\}$. Input bits $u_0, u_1, \ldots, u_7$ include both Type I (6 bits) and Type II (2 bits) information, which are encoded to $c_0$ to $c_7$ using a Polar coding scheme. In some embodiments, the Type II information may be positioned to indices 3 and 7. In some embodiments, the encoded bits c3 and c7 may be retransmitted several times.

In some embodiments, the decoding node first extracts the LLR of bits at indices 3 and 7 for Type II information based on the assigned indices for the set S. For example, it may be known that $c_3$ and $c_7$ are decided by $u_3$ and $u_7$ only. Thus, the LLR values of indices 3 and 7 lead to values of $u_3$ and $u_7$. Based on information included in $u_3$ and $u_7$, the decoding node can derive the length of information Type I.

In some embodiments, the decoding node may use the decoded $u_3$ and $u_7$ as known bits when decoding the N-bit Polar code to obtain information Type I. In some implementations, the decoding node may descramble the bits for information Type II (e.g., $c_3$ and/or $c_7$) prior to performing the decoding the information Type I. The decoding node may also set the bits in set S (i.e., bits for information Type II) to 0 when it decodes the bits for information Type I.

## Example Embodiment 2

In this particular example, the Polar code has a total number of N=256 bits. For simplicity's sake, 128 bits among the 256 bits are input bits (i.e., K=128). Set S has n=32 indices. The length of Type II information is $k_2 = 15$, which is smaller than n.

In some embodiments, the set S is the initial 32 indices of all possible indices: {0, 1, 2, 3, ... ,31}. The set S can also be the last 32 indices of all possible indices: {224, 225, 226, ... , 253, 254, 255}. In some implementations, the Set S includes indices distributed over possible indices: {7, 15, 23, 31, ... , 231, 239, 247, 255}. Indices in Set I can be decided based on the set S to ensure that set S and set I have a common subset of indices.

The encoding node chooses 15 indices in Set S to place Type II information. In some embodiments, the encoding node selects the 15 indices based on reliability, BER, and/or both. The selected indices (e.g., 15 indices) can be calculated using methods such as density evolution or Gaussian approximation. In some embodiment, the selected indices are chosen by a predefined sequence. After placing Type II information in the selected 15 indices, the encoding node places Type I information in the remaining indices in set I.

In some embodiments, the decoding node first extracts the LLR of bits at indices in S for Type II information. Based on information included in $k_2$ bits, the decoding node can derive the length of information Type I and decode information Type I accordingly.

In some embodiments, the decoding node may use the decoded $k_2$ bits as known bits when decoding the 256-bit Polar code to obtain information Type I. In some implementations, the decoding node may descramble the $k_2$ bits for information Type II prior to performing the decoding the information Type I. For example, as a part of descrambling, the decoding node may inverse the sign of log-likelihood ratio $LLR_k$ of any $c_k=1$, while maintaining the sign of $LLR_k$ of any $c_k=0$, where $c_k$ are encoded bits for information Type II. The decoding node may also set the bits in set S (i.e., bits for information Type II) to 0 when it decodes the bits for information Type I.

## Example Embodiment 3

In this particular example, the Polar code has a total number of N=256 bits. The size of set S is n=15 indices. The length of Type I information $k_1 = 17$, and the length of Type II information $k_2 = 15$. For simplicity's sake, only 32 bits ($k_1 + k_2 = 32$) are input bits (i.e., K=32). In some embodiments, indices in set I for the K input bits can be ordered based on reliability (e.g., low to high, or high to low), which may be calculated using methods such as density evolution and/or Gaussian approximation. The indices in set I may also be chosen by a predefined sequence. For example, set I for K input bits can be {126, 241, 187, 236, 242, 215, 189, 244, 190, 219, 231, 248, 221, 235, 222, 127, 237, 243, 238, 245, 191, 246, 249, 250, 223, 252, 239, 247, 251, 253, 254, 255} with reliability ordered from low to high.

The encoding node chooses 15 indices in set S to place Type II information. In some embodiments, the encoding node selects the indices based on reliability, BER, and/or both. For example, set S can be the 15 indices with lowest reliability in Set I: {126, 241, 187, 236, 242, 215, 189, 244, 190, 219, 231, 248, 221, 235, 222}. In some embodiments, Set S can simply be the 15 smallest indices in Set I: {126, 127, 187, 189, 190, 191, 215, 219, 221, 222, 223, 231, 235, 236, 237}.

In some embodiments, the decoding node may use the decoded $k_2$ bits as known bits when decoding the 256-bit Polar code to obtain information Type I. In some implementations, the decoding node may descramble the $k_2$ bits for information Type II prior to performing the decoding the information Type I. For example, as a part of descrambling, the decoding node may inverse the sign of log-likelihood ratio $LLR_k$ of any $c_k=1$, while maintaining the sign of $LLR_k$ of any $c_k=0$, where $c_k$ are encoded bits for information Type II. The decoding node may also set the bits in set S (i.e., bits for information Type II) to 0 when it decodes the bits for information Type I.

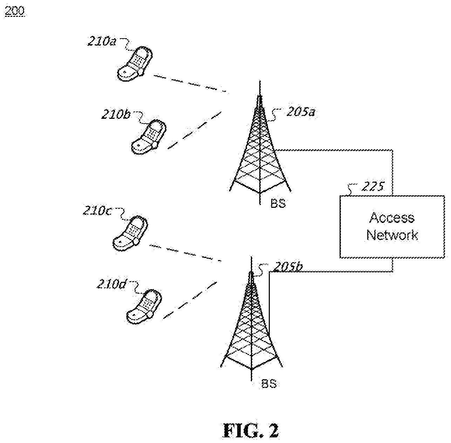

FIG. 2 shows an example of a wireless communication system where techniques in accordance with one or more embodiments of the present technology can be applied. A wireless communication system 400 can include one or more base stations (BSs) 205a, 205b, one or more wireless devices 210a, 210b, 210c, 210d, and an access network 225. A base station 205a, 205b can provide wireless service to wireless devices 210a, 210b, 210c and 210d in one or more wireless sectors. In some implementations, a base station 205a, 205b includes directional antennas to produce two or more directional beams to provide wireless coverage in different sectors.

The access network 225 can communicate with one or more base stations 205a, 205b. In some implementations, the access network 225 includes one or more base stations 205a, 205b. In some implementations, the access network 225 is in communication with a core network (not shown in FIG. 2) that provides connectivity with other wireless communication systems and wired communication systems. The core network may include one or more service subscription databases to store information related to the subscribed wireless devices 210a, 210b, 210c and 210d. A first base station 205a can provide wireless service based on a first radio access technology, whereas a second base station 205b can provide wireless service based on a second radio access technology. The base stations 205a and 205b may be co-located or may be separately installed in the field according to the deployment scenario. The access network 225 can support multiple different radio access technologies.

In some implementations, a wireless communication system can include multiple networks using different wireless technologies. A dual-mode or multi-mode wireless device includes two or more wireless technologies that could be used to connect to different wireless networks.

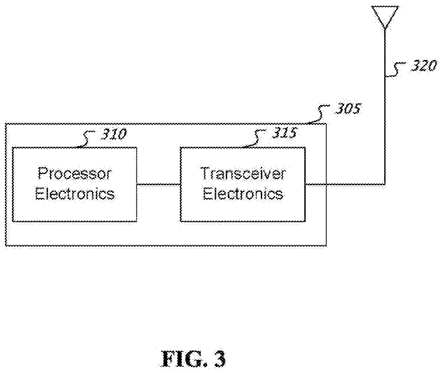

FIG. 3 is a block diagram representation of a portion of a radio station. A radio station 305 such as a base station or a wireless device (or UE) can include processor electronics 310 such as a microprocessor that implements one or more of the wireless techniques presented in this document. The radio station 305 can include transceiver electronics 315 to send and/or receive wireless signals over one or more communication interfaces such as antenna 320. The radio station 305 can include other communication interfaces for transmitting and receiving data. Radio station 305 can include one or more memories (not explicitly shown) configured to store information such as data and/or instructions. In some implementations, the processor electronics 310 can include at least a portion of the transceiver electronics 315. In some embodiments, at least some of the disclosed techniques, modules or functions are implemented using the radio station 305.

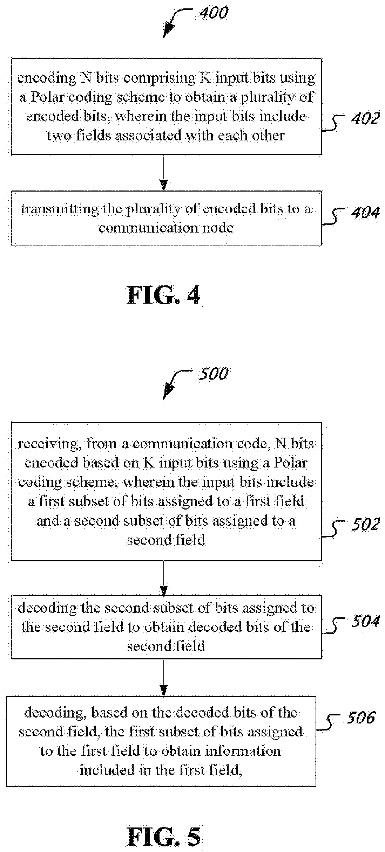

FIG. 4 is a flowchart representation of a method for wireless communication 400. The method 400 includes, at 402, encoding N bits comprising K input bits using a Polar coding scheme to obtain a plurality of encoded bits, wherein the input bits include two fields associated with each other. The method 400 also includes, at 404, transmitting the plurality of encoded bits to a communication device. For example, the input bits has a total size of K bits among a N-bit Polar code. The input bits includes a first subset of bits assigned to a first field and a second subset of bits assigned to a second field that is associated with the first field. The second subset of bits are positioned based on an index set including n indices. All of N, K, and n are positive integers, N being equal to or greater than n, and K being equal to or smaller than N.

FIG. 5 shows a flowchart representation of another method for wireless communication 500. The method 500 includes, at 502, receiving, from a communication node, N bits encoded based on K input bits using a Polar coding scheme, wherein the input bits include a first subset of bits assigned to a first field and a second subset of bits assigned to a second field. The second subset of bits are positioned based on an index set including n indices. The method 500 includes, at 504, decoding the second subset of bits assigned to the second field to obtain decoded bits of the second field. The method 500 also includes, at 506, decoding, based on the decoded bits of the second field, the first subset of bits assigned to the first field to obtain information included in the first field. All of N, K, and n are positive integers, N is being equal to or greater than n, and K being equal to or smaller than N.

It is thus evident that this patent document describes techniques that use joint coding of related types of information in Polar coding to avoid unnecessary padding bits. The techniques can minimize the amount of blind detection required to decode information that has varying bit lengths. Using the disclosed techniques, there is no need to add padding bits in the input bits of the Polar codes, thereby minimizing impact to the BLER and enhancing BER performance for information Type II.

From the foregoing, it will be appreciated that specific embodiments of the presently disclosed technology have been described herein for purposes of illustration, but that various modifications may be made. Accordingly, the presently disclosed technology is not limited except as by the appended claims.

The disclosed and other embodiments, modules and the functional operations described in this document can be implemented in digital electronic circuitry, or in computer software, firmware, or hardware, including the structures disclosed in this document and their structural equivalents, or in combinations of one or more of them. The disclosed and other embodiments can be implemented as one or more computer program products, i.e., one or more modules of computer program instructions encoded on a computer readable medium for execution by, or to control the operation of, data processing apparatus. The computer readable medium can be a machine-readable storage device, a machine-readable storage substrate, a memory device, a composition of matter effecting a machine-readable propagated signal, or a combination of one or more them. The term "data processing apparatus" encompasses all apparatus, devices, and machines for processing data, including by way of example a programmable processor, a computer, or multiple processors or computers. The apparatus can include, in addition to hardware, code that creates an execution environment for the computer program in question, e.g., code that constitutes processor firmware, a protocol stack, a database management system, an operating system, or a combination of one or more of them. A propagated signal is an artificially generated signal, e.g., a machine-generated electrical, optical, or electromagnetic signal, that is generated to encode information for transmission to suitable receiver apparatus.

A computer program (also known as a program, software, software application, script, or code) can be written in any form of programming language, including compiled or interpreted languages, and it can be deployed in any form, including as a stand-alone program or as a module, component, subroutine, or other unit suitable for use in a computing environment. A computer program does not necessarily correspond to a file in a file system. A program can be stored in a portion of a file that holds other programs or data (e.g., one or more scripts stored in a markup language document), in a single file dedicated to the program in question, or in multiple coordinated files (e.g., files that store one or more modules, sub programs, or portions of code). A computer program can be deployed to be executed on one computer or on multiple computers that are located at one site or distributed across multiple sites and interconnected by a communication network.

The processes and logic flows described in this document can be performed by one or more programmable processors executing one or more computer programs to perform functions by operating on input data and generating output. The processes and logic flows can also be performed by, and apparatus can also be implemented as, special purpose logic circuitry, e.g., an FPGA (field programmable gate array) or an ASIC (application specific integrated circuit).

Processors suitable for the execution of a computer program include, by way of example, both general and special purpose microprocessors, and any one or more processors of any kind of digital computer. Generally, a processor will receive instructions and data from a read only memory or a random access memory or both. The essential elements of a computer are a processor for performing instructions and one or more memory devices for storing instructions and data. Generally, a computer will also include, or be operatively coupled to receive data from or transfer data to, or both, one or more mass storage devices for storing data, e.g., magnetic, magneto optical disks, or optical disks. However, a computer need not have such devices. Computer readable media suitable for storing computer program instructions and data include all forms of non-volatile memory, media and memory devices, including by way of example semiconductor memory devices, e.g., EPROM, EEPROM, and flash memory devices; magnetic disks, e.g., internal hard disks or removable disks; magneto optical disks; and CD ROM and DVD-ROM disks. The processor and the memory can be supplemented by, or incorporated in, special purpose logic circuitry.

Certain features that are described in this document in the context of separate embodiments can also be implemented in combination in a single embodiment. Conversely, various features that are described in the context of a single embodiment can also be implemented in multiple embodiments separately or in any suitable sub-combination. Similarly, while operations are depicted in the drawings in a particular order, this should not be understood as requiring that such operations be performed in the particular order shown or in sequential order, or that all illustrated operations be performed, to achieve desirable results.

Only a few examples and implementations are disclosed. Variations, modifications, and enhancements to the described examples and implementations and other implementations can be made based on what is disclosed.

## Claims

1. A method for wireless communication, comprising:

    encoding N bits comprising K input bits using a Polar coding scheme to obtain a plurality of encoded bits, wherein the K input bits include a first subset of bits assigned to a first field and a second subset of bits assigned to a second field that is associated with the first field, and the second subset of bits are positioned based on an index set including n indices; and
transmitting the plurality of encoded bits to a communication device,
wherein all of N, K, and n are positive integers, N being equal to or greater than n, and K being equal to or smaller than N;
wherein the K input bits encode information; and
wherein the second field includes information indicative of a length of the first field; and the method comprising positioning the second subset of bits at a plurality of indices determined by a communication device based on the index set, wherein the index set includes following indices:

$$\left\lfloor \frac{N}{n} \right\rfloor - 1, \left\lfloor \frac{2N}{n} \right\rfloor - 1, ..., \text{N-1},$$

or

$$\text{N-n, N-n+1, ..., N-1}.$$

2. The method of claim 1,

wherein the encoding of the plurality of input bits is performed such that the second subset of bits of the plurality of input bits assigned to the second field is self-decodable, or
wherein the encoding of the plurality of input bits is performed such that the second subset of bits of the plurality of input bits assigned to the second field is decoded prior to a first subset of bits of the plurality of input bits assigned to the first field.

3. The method of claim 1, wherein information included in the second field has a lower bit error rate requirement than information included in the first field.

4. A method for wireless communication, comprising:

receiving, from a communication node, N bits encoded based on K input bits using a Polar coding scheme, wherein the K input bits include a first subset of bits assigned to a first field and a second subset of bits assigned to a second field that is associated with the first field, and the second subset of bits are positioned based on an index set including n indices;
decoding the second subset of bits assigned to the second field to obtain decoded bits of the second field; and

decoding, based on the decoded bits of the second field, the first subset of bits assigned to the first field to obtain information included in the first field,
wherein all of N, K, and n are positive integers, N is being equal to or greater than n, and K being equal to or smaller than N; and
wherein the decoded bits of the second field includes information that is indicative of a length of the first field; and
wherein the second subset of bits are positioned at a plurality of indices determined by a communication device based on the index set, the index set including following indices:

$$\left\lfloor \frac{N}{n} \right\rfloor - 1, \left\lfloor \frac{2N}{n} \right\rfloor - 1, ..., \text{N-1},$$

or

$$\text{N-n, N-n+1, ..., N-1}.$$

5. The method of claim 4, wherein information included in the second field has a lower bit error rate requirement than information included in the first field.

6. The method of claim 4, wherein the second subset of bits assigned to the second field is self-decodable, or
wherein the second subset of bits assigned to the second field is decoded prior to the first subset of bits assigned to the first field.

7. The method of claim 4, wherein the decoding of the first subset of bits assigned to the first field uses the decoded bits of the second field as known bits.

8. The method of claim 4, further comprising descrambling the second subset of bits prior to decoding the first subset of bits, wherein the descrambling of the second subset of bits preferably includes inverting a sign of log-likelihood ratio at an index with a non-zero bit of the second subset of bits, more preferably further comprising, prior to decoding the first subset of bits assigned to the first field, setting the second subset of bits to zero.

9. The method recited in claims 1 to 8, wherein the N bits include the K input bits and a set of bits, wherein:

each of the set of bits has a constant value, or
the set of bits is indicative of an identification of a communication device.

10. An apparatus for wireless communication configured to carry out the method of any of claims 1 to 3 or claim 9, or to carry out the method of any of claims 4 to 9.

11. A non-transitory computer readable medium having code stored thereon, the code when executed by a processor, causing the processor to implement a method recited in any of claims 1 to 3 or claim 9 or to implement the method of any of claims 4 to 9.

**Patentansprüche**

1. Verfahren für Drahtloskommunikation, umfassend:

Codieren von N Bits, die K Eingangsbits aufweisen, unter Verwendung eines Polarcodierungsschemas, um eine Vielzahl codierter Bits zu erhalten, wobei die K Eingangsbits eine erste Teilmenge von Bits, die einem ersten Feld zugeordnet sind, sowie eine zweite Teilmenge von Bits enthalten, die einem zweiten Feld zugeordnet sind, welches dem ersten Feld zugewiesen ist, und die zweite Teilmenge von Bits basierend auf einer Index-Menge positioniert werden, welche n Indizes enthält; und
Übertragen der Vielzahl codierter Bits an eine Kommunikationsvorrichtung,
wobei N, K und n alle positive ganze Zahlen sind, N gleich oder größer als n ist und K gleich oder kleiner als N ist;
wobei die K Eingangsbits Informationen codieren; und
wobei das zweite Feld Informationen enthält, die eine Länge des ersten Felds angeben; und
wobei das Verfahren das Positionieren der zweiten Teilmenge von Bits an einer Vielzahl von Indizes umfasst, die durch eine Kommunikationsvorrichtung basierend auf der Index-Menge bestimmt werden, wobei die Index-Menge die folgenden Indizes enthält:

$$\left\lfloor \frac{N}{n} \right\rfloor - 1, \left\lfloor \frac{2N}{n} \right\rfloor - 1, \ldots, \text{N-1},$$

oder

$$\text{N-n, N-n+1, } \ldots, \text{ N-1}.$$

2. Verfahren nach Anspruch 1,

wobei das Codieren der Vielzahl von Eingangsbits derart durchgeführt wird, dass die zweite Teilmenge von Bits der Vielzahl von Eingangsbits, die dem zweiten Feld zugeordnet sind, selbst-decodierbar ist, oder
wobei das Codieren der Vielzahl von Eingangsbits derart durchgeführt wird, dass die zweite Teilmenge von Bits der Vielzahl von Eingangsbits, die dem zweiten Feld zugeordnet ist, vor einer ersten Teilmenge von Bits der Vielzahl von Eingangsbits decodiert wird, die dem ersten Feld zugeordnet sind.

3. Verfahren nach Anspruch 1, wobei die in dem zweiten Feld enthaltenen Informationen eine niedrigere Anforderung an die Bitfehlerrate haben als die in dem ersten Feld enthaltenen Informationen.

4. Verfahren zur Drahtloskommunikation, umfassend:

Empfangen, von einem Kommunikationsknoten, von N Bits, die basierend auf K Eingangsbits unter Verwendung eines Polarcodierungsschemas codiert sind, wobei die K Eingangsbits eine erste Teilmenge von Bits, die einem ersten Feld zugeordnet sind, sowie eine zweite Teilmenge von Bits enthalten, die einem zweiten Feld zugeordnet sind, das dem ersten Feld zugewiesen ist, und die zweite Teilmenge von Bits basierend auf einer Index-Menge positioniert werden, welche n Indizes enthält;
Decodieren der zweiten Teilmenge von Bits, die dem zweiten Feld zugeordnet werden, um decodierte Bits des zweiten Felds zu erhalten, und
Decodieren, basierend auf den decodierten Bits des zweiten Felds, der ersten Teilmenge von Bits, die dem ersten Feld zugeordnet sind, um Informationen zu erhalten, die in dem ersten Feld enthalten sind,
wobei N, K und n alle positive ganze Zahlen sind, N gleich oder größer als n ist und K gleich oder kleiner als N ist; und
wobei die decodierten Bits des zweiten Felds Informationen umfassen, die eine Länge des ersten Felds angeben; und
wobei die zweite Teilmenge von Bits an einer Vielzahl von Indizes positioniert werden, die durch eine Kommunikationsvorrichtung basierend auf der Index-Menge bestimmt werden, wobei die Index-Menge die folgenden Indizes enthält:

$$\left\lfloor \frac{N}{n} \right\rfloor - 1, \left\lfloor \frac{2N}{n} \right\rfloor - 1, \ldots, \text{N-1},$$

oder

$$\text{N-n, N-n+1, } \ldots, \text{ N-1}.$$

5. Verfahren nach Anspruch 4, wobei die in dem zweiten Feld enthaltenen Informationen eine niedrigere Anforderung an die Bitfehlerrate haben als die in dem ersten Feld enthaltenen Informationen.

**6.** Verfahren nach Anspruch 4, wobei die zweite Teilmenge von Bits, die dem zweiten Feld zugeordnet ist, selbst-decodierbar ist, oder wobei die zweite Teilmenge von Bits, die dem zweiten Feld zugeordnet sind, vor der ersten Teilmenge von Bits decodiert wird, die dem ersten Feld zugeordnet ist.

**7.** Verfahren nach Anspruch 4, wobei das Decodieren der ersten Teilmenge von Bits, die dem ersten Feld zugeordnet sind, die decodierten Bits des zweiten Felds als bekannte Bits verwendet.

**8.** Verfahren nach Anspruch 4, ferner umfassend das Entschlüsseln der zweiten Teilmenge von Bits vor dem Decodieren der ersten Teilmenge von Bits, wobei das Entschlüsseln der zweiten Teilmenge von Bits bevorzugt das Invertieren eines Vorzeichens des Log-Likelihood-Verhältnisses an einem Index mit einem Nicht-Null-Bit der zweiten Teilmenge von Bits umfasst, besonders bevorzugt ferner umfassend, vor dem Decodieren der ersten Teilmenge von Bits, die dem ersten Feld zugeordnet sind, Setzen der zweiten Teilmenge von Bits auf Null.

**9.** Verfahren nach einem der Ansprüche 1 bis 8, wobei die N Bits die K Eingangsbits und eine Menge Bits umfassen, wobei

jedes der Menge von Bits einen konstanten Wert hat, oder
die Menge von Bits eine Kennung einer Kommunikationsvorrichtung angibt.

**10.** Vorrichtung für Drahtloskommunikation, welche konfiguriert ist, das Verfahren nach einem der Ansprüche 1 bis 3 oder Anspruch 9 durchzuführen, oder das Verfahren nach einem der Ansprüche 4 bis 9 durchzuführen.

**11.** Nichtflüchtiges, computerlesbares Medium mit darauf gespeichertem Code, wobei der Code, wenn er von einem Prozessor ausgeführt wird, den Prozessor veranlasst, ein Verfahren nach einem der Ansprüche 1 bis 3 oder Anspruch 9 durchzuführen oder das Verfahren nach einem der Ansprüche 4 bis 9 durchzuführen.

**Revendications**

**1.** Procédé de communication sans fil, comprenant :

l'encodage de N bits comprenant K bits d'entrée en utilisant un schéma de codage polaire pour obtenir une pluralité de bits encodés, dans lequel les K bits d'entrée comportent un premier sous-ensemble de bits attribué à un premier champ et un deuxième sous-ensemble de bits attribué à un deuxième champ qui est associé au premier champ, et le deuxième sous-ensemble de bits est positionné sur la base d'un ensemble d'indices comportant n indices ; et
la transmission de la pluralité de bits encodés à un dispositif de communication,
dans lequel tous les N, K et n sont des nombres entiers positifs, N étant supérieur ou égal à n, et K étant inférieur ou égal à N ;
dans lequel les K bits d'entrée encodent des informations ; et
dans lequel le deuxième champ comporte des informations indiquant une longueur du premier champ ; et
le procédé comprenant le positionnement du deuxième sous-ensemble de bits sur une pluralité d'indices déterminés par un dispositif de communication sur la base de l'ensemble d'indices, dans lequel l'ensemble d'indices comporte des indices suivants :

$$\left\lfloor \frac{N}{n} \right\rfloor - 1, \left\lfloor \frac{2N}{n} \right\rfloor - 1, \dots, \text{N-1},$$

ou

$$\text{N-n}, \text{N-n+1}, \dots, \text{N-1}.$$

**2.** Procédé selon la revendication 1,

dans lequel l'encodage de la pluralité de bits d'entrée est réalisé de telle sorte que le deuxième sous-ensemble de bits de la pluralité de bits d'entrée attribués au deuxième champ est auto-décodable, ou
dans lequel l'encodage de la pluralité de bits d'entrée est réalisé de telle sorte que le deuxième sous-ensemble de bits de la pluralité de bits d'entrée attribués au deuxième champ est décodé avant un premier sous-ensemble de bits de la pluralité de bits d'entrée attribués au premier champ.

**3.** Procédé selon la revendication 1, dans lequel des informations comprises dans le deuxième champ présentent une exigence inférieure en termes de taux d'erreur de bit à celle d'informations comprises dans le premier champ.

**4.** Procédé de communication sans fil comprenant :

la réception, depuis un noeud de communication, de N bits encodés sur la base de K bits d'entrée en utilisant un schéma de codage polaire, dans lequel les K bits d'entrée comportent un premier sous-ensemble de bits attribué à un premier champ et un deuxième sous-ensemble de bits attribué à un deuxième champ qui est associé au premier champ, et le deuxième sous-ensemble de bits est positionné sur la base d'un ensemble d'indices comportant n indices ;

le décodage du deuxième sous-ensemble de bits attribué au deuxième champ pour obtenir des bits décodés du deuxième champ ; et

le décodage, sur la base des bits décodés du deuxième champ, du premier sous-ensemble de bits attribué au premier champ pour obtenir des informations comprises dans le premier champ,

dans lequel tous les N, K et n sont des nombres entiers positifs, N étant supérieur ou égal à n, et K étant inférieur ou égal à N ; et

dans lequel les bits décodés du deuxième champ comportent des informations indiquant une longueur du premier champ ; et

dans lequel le deuxième sous-ensemble de bits est positionné sur une pluralité d'indices déterminés par un dispositif de communication sur la base de l'ensemble d'indices, l'ensemble d'indices comportant des indices suivants :

$$\left\lfloor \frac{N}{n} \right\rfloor - 1, \left\lfloor \frac{2N}{n} \right\rfloor - 1, \ldots, \text{N-1},$$

ou

$$\text{N-n, N-n+1}, \ldots, \text{N-1}.$$

5. Procédé selon la revendication 4, dans lequel des informations comprises dans le deuxième champ présentent une exigence inférieure en termes de taux d'erreur de bit à celle d'informations comprises dans le premier champ.

6. Procédé selon la revendication 4, dans lequel le deuxième sous-ensemble de bits attribué au deuxième champ est auto-décodable, ou dans lequel le deuxième sous-ensemble de bits attribué au deuxième champ est décodé avant le premier sous-ensemble de bits attribué au premier champ.

7. Procédé selon la revendication 4, dans lequel le décodage du premier sous-ensemble de bits attribué au premier champ utilise les bits décodés du deuxième champ comme des bits connus.

8. Procédé selon la revendication 4, comprenant en outre le désembrouillage du deuxième sous-ensemble de bits avant de décoder le premier sous-ensemble de bits, dans lequel le désembrouillage du deuxième sous-ensemble de bits comporte de manière préférée l'inversion d'un signe de logarithme de rapport de vraisemblance à un indice avec un bit non nul du deuxième sous-ensemble de bits, comprenant en outre de manière davantage préférée, avant le décodage du premier sous-ensemble de bits attribué au premier champ, le réglage du deuxième sous-ensemble de bits sur zéro.

9. Procédé selon les revendications 1 à 8, dans lequel les N bits comporte les K bits d'entrée et un ensemble de bits, dans lequel :

chaque ensemble de bits présente une valeur constante, ou
l'ensemble de bits indique une identification d'un dispositif de communication.

10. Appareil de communication sans fil configuré pour réaliser le procédé selon l'une quelconque des revendications 1 à 3 ou selon la revendication 9, ou pour réaliser le procédé selon l'une quelconque des revendications 4 à 9.

11. Support lisible par ordinateur non transitoire présentant un code stocké sur celui-ci, le code amenant, lorsqu'il est exécuté par un processeur, le processeur à mettre en oeuvre un procédé selon l'une quelconque des revendications 1 à 3 ou selon la revendication 9 ou à mettre en oeuvre le procédé selon l'une quelconque des revendications 4 à 9.

**FIG. 1**

**FIG. 2**

**FIG. 3**

EP 3 695 514 B1

400

encoding N bits comprising K input bits using
a Polar coding scheme to obtain a plurality of
encoded bits, wherein the input bits include
two fields associated with each other

402

transmitting the plurality of encoded bits to a
communication node

404

**FIG. 4**

500

receiving, from a communication code, N bits
encoded based on K input bits using a Polar
coding scheme, wherein the input bits include
a first subset of bits assigned to a first field
and a second subset of bits assigned to a
second field

502

decoding the second subset of bits assigned to
the second field to obtain decoded bits of the
second field

504

decoding, based on the decoded bits of the
second field, the first subset of bits assigned
to the first field to obtain information
included in the first field,

506

**FIG. 5**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3454491 A1

- WO 2019033078 A1

**Non-patent literature cited in the description**

- *UCI, R1-1718413 Prague,* 08 October 2017